# EUROPEAN PATENT APPLICATION

(11) **EP 4 852 659 A1**
(43) Date of publication of application: **09.12.2026**
(21) Application number: 25180522.2
(22) Date of filing: 03.06.2025
(51) Int. Cl.: H10F 19/80, H10F 19/90

(54) **PHOTOVOLTAIC MODULE WITH IMPROVED RECYCLING CAPACITY AND METHOD FOR MANUFACTURING THE SAME**

(71) Applicant: Nederlandse Organisatie voor toegepast- natuurwetenschappelijk onderzoek TNO, 2595 DA 's-Gravenhage (NL)
(72) Inventor: OKEL, Lars Arjan Gustaaf, 2595 DA's-Gravenhage (NL); GUILLEVIN, Nicolas, 2595 DA's-Gravenhage (NL)
(74) Representative: V.O.

(57) **Abstract**

The present disclosure relates to a photovoltaic module comprising a front panel, a rear panel opposite the front panel and a solar cell arrangement comprising a plurality of electrically interconnected solar cells. The solar cell arrangement is packed between the front and rear panel and an edge sealant is located between an edge of the rear panel and an edge of the front panel. The edge sealant is configured for forming an air-tight area between the front and rear panel such that the solar cell arrangement packed between the front and rear panel is air-tightly closed off. The air-tight area is under vacuum with a vacuum pressure equal or below 200 mbar, preferably equal or below 100 mbar, more preferably equal or below 10 mbar. In this way, the solar cell arrangement is maintained squeezed between the front and rear panel. The present disclosure also relates to a method for manufacturing a photovoltaic module.

## Description

### Field of the disclosure

The present disclosure relates to a photovoltaic module comprising a solar cell arrangement having a plurality of electrically interconnected solar cells. In particular, the present disclosure relates to encapsulant free photovoltaic modules. The present disclosure further relates to a method for manufacturing such photovoltaic modules.

### Background

Photovoltaic (PV) modules are widely used as a means of generating electricity from solar energy. Conventional PV modules typically comprise a stack of components including a front glass sheet, one or more polymer-based encapsulant layers, photovoltaic cells, and a backsheet or second glass layer. The encapsulant, usually made of ethylene vinyl acetate (EVA), polyolefin elastomer (POE), or other thermoplastic or thermoset polymers, serves multiple purposes: it mechanically stabilizes the solar cells, provides environmental protection against moisture and oxygen, electrically insulates the components, and ensures optical clarity to enable efficient light transmission to the active surface of the cells.

During manufacturing of these conventional PV modules, the various components are laminated under heat and pressure, causing the encapsulant to flow, fill voids, and cure into a solid layer that bonds the module together.

Although this conventional PV module configuration has become the industry standard due to its established performance and scalability, it also presents significant drawbacks, particularly in the context of long-term durability and end-of-life management.

A first problem associated with encapsulated PV modules is the chemical and mechanical degradation of the encapsulant over time, which may lead to an operational degradation of the solar cells.

A second problem is that the use of crosslinked encapsulant materials poses a substantial barrier to recycling and reuse of the PV module components. Once molted or cured, the encapsulant polymers cannot be easily separated from adjacent layers, making it extremely difficult to recover clean glass, silicon wafers, and valuable metals without extensive mechanical or chemical processing. As a result, the recycling of conventional PV modules remains economically and technically challenging, with current methods often involving shredding and thermal treatment, which compromise material purity and value.

With the rapid growth of solar deployment globally there is a need for PV module designs that enable disassembly, repair, refurbishment, and high-yield recycling, while maintaining acceptable electrical and mechanical performance during the module's service life.

Hence, there is room for improving PV modules and manufacturing PV modules.

### Summary

It is an object of the present disclosure to provide a robust PV module with improved recyclability when compared to conventional PV models. A further object is to provide an efficient and cost-effective manufacturing method for manufacturing such circular PV modules.

The present disclosure is defined in the appended independent claims. The dependent claims define advantageous embodiments.

According to a first aspect of the disclosure, a PV module is provided.

The photovoltaic module comprises: a front panel; a rear panel opposite the front panel; a solar cell arrangement comprising a plurality of electrically interconnected solar cells, and wherein the solar cell arrangement is packed between the front and rear panel, and an edge sealant located between an edge of the rear panel and an edge of the front panel, and wherein the edge sealant is configured for forming an air-tight area between the front and rear panel such that the solar cell arrangement packed between the front and rear panel is air-tightly closed off, and wherein the air-tight area is under vacuum with a vacuum pressure equal or below 200 mbar, preferably equal or below 100 mbar, more preferably equal or below 10 mbar, such that the solar cell arrangement is maintained squeezed between the front and rear panel.

Advantageously, due to the vacuum in the air-tightly sealed off area between front and rear panels, the atmospheric pressure provides for a permanent mechanical pressure maintaining the solar cell arrangement squeezed between the front and rear panel. In this way, a mechanically solid fixation is obtained holding the solar cell arrangement between the panels and keeping it in position during the entire lifetime of the PV module. Hence, there is no need to use any encapsulant or any layers of glue to keep the solar cell arrangement in place.

A further advantage relates to temperature stabilization of the PV module. By pressing the solar cells against the panels, dissipated power can more efficiently be transferred through the glass panels. Indeed, the entire surface of each of the solar cells is in contact with the glass panel.

In addition, by bringing the solar cells fully in contact with the glass panels, the risk of hot cell or hotspots to occur during the lifetime of the PV module is reduced due to the optimal heat exchange between the cells and the glass panels.

The edge sealant not only maintains the vacuum between the front and rear panel, it also prevents moisture from coming inside the PV module.

Further, the edge sealant also acts as a spacer between the front and rear panels. For instance, due to differences in thermal extension and mechanical forces such as wind and snow load, the glass panels may move freely with respect to each other.

Advantageously, disassembly and material recovery at the end of the PV module product's useful life is facilitated. Indeed, after the PV module lifetime, the glass enclosure may be opened by punching the sides with a knife, which allows air to flow inwards and the vacuum to disappear. After removal of the front panel, the entire solar cell arrangement, i.e. the back-contact based semi fabricate can be taken out. The remaining components such as the solar cells, the isolation layer and the conductive backsheet can be easily separated, either at room temperature or at a higher temperature, for example by heating to a temperature of about 140°C or more.

In embodiments, as mentioned above, the solar cells, more specifically the front sides of the solar cells are advantageously contacting the front panel, e.g. glass front panel.

For instance, in embodiments, each of the plurality of solar cells may be a back contact solar cell wherein a backside of the solar cell comprises one or more electrical contacts for interconnecting the solar cells, and wherein the backside is facing towards the rear panel and a frontside of the solar cell, opposite the backside, is facing the front panel. In this way, the front side of the solar cells may be in full contact with the front panel such that an optimum heat exchange may be obtained between the solar cells and the front panel.

Typically, the solar cell arrangement comprises a patterned connecting circuit electrically interconnecting the plurality of solar cells.

In embodiments, a conductive backsheet is forming the patterned connecting circuit, and wherein the solar cell arrangement further comprises: an isolation layer separating the conductive backsheet from the backside of the plurality of solar cells; a plurality of interconnections configured for electrically and mechanically connecting the one or more contacts of each of the solar cells with the conductive backsheet, and wherein the one or more interconnections are disposed through corresponding interconnection holes provided in the isolation layer.

Generally, the conductive backsheet is forming a foil. In embodiments, the conductive backsheet comprises a polymer carrier film and a patterned copper top layer.

Generally, the PV module comprises at least one output terminal, wherein the at least one output terminal comprises one or more electrical wires that are electrically connected with the connecting circuit located inside the air-tight area.

Advantageously, by using back contact solar cells in combination with a conductive backsheet, a flat solar cell arrangement may be obtained which allows the solar cell arrangement to be uniformly squeezed in between the front and rear panel of the PV module.

The PV module is an encapsulant free module, preferably wherein no encapsulant foil, such as for example an EVA or POE foil, is covering or partly covering the solar cell arrangement, or, the PV is module is a module wherein no layer of glue is provided between the front panel and the solar cell arrangement and no layer of glue is provided between the rear panel and the solar cell arrangement. Further, no glue is required to bound the conductive backsheet to the solar cells.

In embodiments, the edge sealant comprises one or more layered flexible tapes, preferably wherein the edge sealant comprises at least two layers of flexible tape wherein a first flexible tape is contacting the rear panel and a second flexible tape, placed on top of the first flexible tape, is contacting the front panel.

In embodiments, the front panel is made of a transparent material, preferably wherein the front panel is made of glass, and/or wherein the rear panel is made of a transparent material, preferably wherein the rear panel is made of glass.

In embodiments, a thickness T of the solar cell arrangement is between 0.1 to 3 mm, preferably between 0.2 to 2 mm, more preferably between 0.5 to 1 mm.

In embodiments, the edge sealant may have a width WS, between 7 and 15 mm and a thickness TS between 0.1 mm and 6.0 mm, preferably a thickness TS between 0.1 mm and 4.0 mm, more preferably a thickness TS between 0.1 mm and 3.0 mm.

Preferably, there is a maximum value for the thickness TS of the edge sealant. This may be expressed as follows: TS ≤ ((SD/(TP x TP x 37.5)) + T), with T being the thickness of the solar cell arrangement, TP being the thickness of the panels and SD being the separation distance between the edge of the solar cels and the edge of the panels.

According to a second aspect of the invention, a method for manufacturing a PV module is provided. The method comprises at least:
a) pre-assembling a photovoltaic module, wherein pre-assembling comprises at least:
   - providing a front and rear panel for forming respectively a front and a rear side of the photovoltaic module,
   - forming a solar cell arrangement by electrically interconnecting a plurality of solar cells,
   - placing the solar cell arrangement between the rear panel and the front panel, and
   - placing an edge sealant between a circumferential edge of the rear panel and a circumferential edge of the front panel,
b) applying a lamination process to the pre-assembled photovoltaic module using a laminator apparatus comprising one or more heating elements and a press mechanism, the lamination process comprising at least:
   - inserting the pre-assembled photovoltaic module in a chamber of the laminator apparatus,
   - pumping air from the chamber such that the entire pre-assembled photovoltaic module becomes placed under vacuum including an area between the front and rear panel, and wherein the vacuum has a vacuum pressure equal or lower than 200 mbar, preferably equal or lower than 100 mbar, more preferably equal or lower than 10 mbar
   - heating the pre-assembled photovoltaic module by using the one or more heating elements,
   - using the press mechanism for exercising a pressure force on an outside surface of the front panel and/or an outside surface of the rear panel such that the front and rear panel are squeezed together while applying the heating,
   - controlling the heating and the pressure force such that the edge sealant is air-tightly sealing off the area between the front and rear panel and the solar cell arrangement packed between the front and rear panel becomes enclosed under vacuum,
   - ventilating the chamber of the lamination apparatus until the chamber reaches atmospheric pressure and removing the photovoltaic module from the lamination apparatus, and wherein due to the vacuum in the air-tightly sealed off area between front and rear panels the atmospheric pressure provides for a permanent mechanical pressure maintaining the solar cell arrangement squeezed between the front and rear panel.

Advantageously, the lamination process according to the present invention involving the creation of a vacuum between the front and rear panel can be performed with a conventional PV laminator apparatus.

Generally, by pumping air from the chamber of the laminator apparatus, air from the area between front and rear panel is evacuated by pumping air through air gaps between the edge sealant and the front panel and/or between the edge sealant and the rear panel. Advantageously, these air gaps are closed off by controlling the heating of the photovoltaic module and by controlling the pressure force.

Typically, the heating of the photovoltaic module is performed until a temperature is reached in a range between 80°C and 200°C, preferably in range between 100°C and 160°C, more preferably until a temperature is reached where the edge sealant starts softening or melting.

Typically, the pressure force exercised by the press mechanism corresponds to a pressure between 5 mbar and 500 mbar, preferably between 10 mbar and 200 mbar, more preferably between 15 mbar and 100 mbar. In embodiments, the pressure force is maintained during a time period between 50 seconds and 300 seconds.

Advantageously, the solar cell arrangement may in a first phase be formed as a semi fabricate, e.g. a back-contact based semi fabricate, and in second phase the semi fabricate may be integrated in between the front and rear panels of a PV module. In this way, the functionality and performance of the cell arrangement, formed as a semi fabricate, can be tested before finalizing the PV module end product.

### Short description of the drawings

These and further aspects of the present disclosure will be explained in greater detail by way of example and with reference to the accompanying drawings in which:
Fig.1 schematically shows a cross-sectional view of an example of an embodiment of a photovoltaic module according to the present disclosure,
Fig.2 schematically shows the layered structure of an example of an embodiment of photovoltaic module, wherein the PV module comprises seventy two solar cells interconnected through a patterned interconnecting circuit,
Fig.3 schematically shows a cross-sectional view of an example of an embodiment of a solar cell arrangement wherein an isolation layer is placed between a conductive backsheet and the solar cells,
Fig.4 schematically shows a cross-sectional view of part of a PV laminator apparatus in an open position, wherein a pre-assembled PV module is placed inside the oven of the PV laminator apparatus for applying a lamination process according to the present invention,
Fig.5 schematically shows the PV laminator apparatus of Fig.4 in a closed position.

The drawings of the figures are neither drawn to scale nor proportioned. Generally, identical components are denoted by the same reference numerals in the figures.

### Detailed description of embodiments

The present disclosure will be described in terms of specific embodiments, which are illustrative of the disclosure and not to be construed as limiting. It will be appreciated by persons skilled in the art that the present disclosure is not limited by what has been particularly shown and/or described and that alternatives or modified embodiments could be developed in the light of the overall teaching of this disclosure. The drawings described are only schematic and are non-limiting.

Use of the verb "to comprise", as well as the respective conjugations, does not exclude the presence of elements other than those stated. Use of the article "a", "an" or "the" preceding an element does not exclude the presence of a plurality of such elements.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein.

Reference throughout this specification to "one embodiment" or "an embodiment" means that a particular feature, structure or characteristic described in connection with the embodiments is included in one or more embodiment of the present disclosure. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one ordinary skill in the art from this disclosure, in one or more embodiments.

According to a first aspect of the disclosure, a lighting unit for emitting a light beam having a characteristic light profile is provided. The lighting units may for instance be used for forming a beacon light or an obstruction light, or any other lighting device wherein the emitted light is subject to strict requirements for what the intensity profile concerns.

### Photovoltaic module

In contrast to standard photovoltaic (PV) modules wherein an encapsulant, e.g. in the form of a foil, is placed around the solar cells, the PV module according to the present invention may be construed as an encapsulant free module. Hence, no encapsulant foils, e.g. ethylene vinyl acetate, known as EVA foils, are covering or partly covering the solar cells as is the case for standard PV modules having an encapsulant. The PV modules according to the present invention may also be construed as PV modules wherein no layer of glue is required between a front panel and a solar cell arrangement and no layer of glue is required between a rear panel and the solar cell arrangement. Additionally, no glue is required to bound a conductive backsheet to the solar cells, as further discussed in more detail here below.

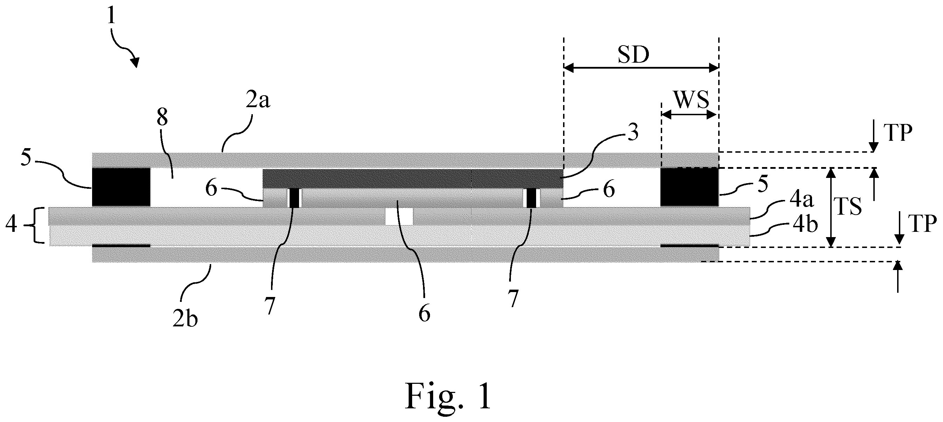

With reference to Fig.1, a PV module 1 according to the present invention is shown. The PV module 1 comprises a front panel 2a and a rear panel 2b opposite the front panel 2a.

The front 2a and rear panel 2b are generally rigid panels.

The front panel 2a is a panel that receives the sun light and hence is for instance made of a transparent material, such as for example glass. The front panel may for instance have a panel thickness TP between 1 mm and 8 mm.

The rear panel 2b may be transparent or not transparent. In embodiments, the rear panel 2b is also transparent and for example also made of glass. The rear panel may for instance have a panel thickness between 1 mm and 8 mm.

In embodiments, the front and rear panel may be glass panels having a thickness between 1 mm and 8 mm, preferably between 1 mm and 7 mm, more preferably between 1 mm and 6 mm.

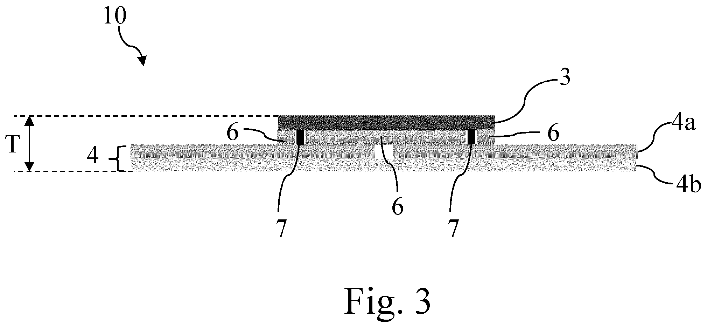

The PV module 1 further comprises a solar cell arrangement comprising a plurality of electrically interconnected solar cells 3. An example of an embodiment of a solar cell arrangement 10 is shown on Fig.3.

The solar cell arrangement 10 generally comprises a patterned connecting circuit 4 for electrically interconnecting the plurality of solar cells 3. The patterned connecting circuit 4 allows to interconnect the solar cells 3 in series or in parallel, or as a combination of a serial and parallel connection.

In embodiments, each of the plurality of solar cells 3 is a back contact solar cell wherein a backside of the solar cell comprises one or more electrical contacts for interconnecting the solar cells. Typically, the contact points are divided in p- and n-type contacts.

The backside of the solar cell is the side that is facing towards the rear panel, and the frontside of the solar cell, opposite the backside, is facing the front panel.

An example of a back contact solar cell that may be used for forming the solar cell arrangement is a so-called IBC cell, interdigitated back contact cell. A further example is a MWT cell, metal wrap trough cell.

In embodiments, the solar cells 3 are conventional mono facial cells having one side configured for receiving sun light, i.e. a front side of the solar cell. In other embodiments, the solar cells may be bifacial cells, wherein both a front side and a back side, opposite the front side, of the solar cell are configured for receiving sun light. Bifacial cells are typically used with PV modules wherein both the front 2a and rear 2b panel are transparent, e.g. front and rear glass panels.

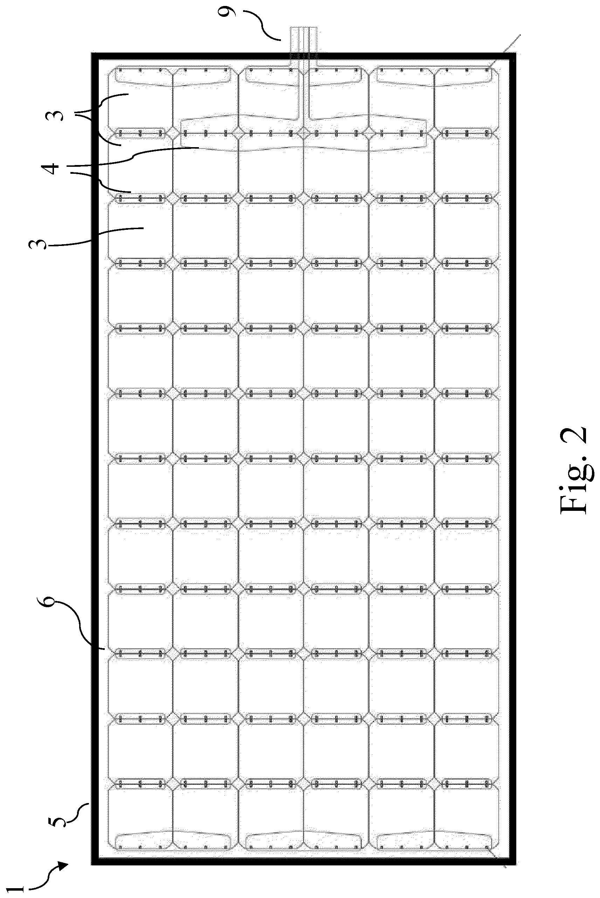

In Fig.1 only one solar cell 3 is schematically shown. In Fig.2 an example of an embodiment of a PV module 1 comprising seventy-two solar cells 3 is schematically shown. The solar cells are placed in a matrix geometry and interconnected with a connecting circuit 4.

In the embodiment shown on Fig.1 and Fig.3, a conductive backsheet 4 is used for forming the connecting circuit.

In embodiments, as schematically illustrated on Fig.3, the conductive backsheet 4 is for example a foil comprising a polymer carrier film 4b and a patterned copper top layer 4a. The patterning may performed by for example milling, LASER ablation or by applying individual copper interconnection islands.

For embodiments of solar cell arrangements 10 as schematically shown on Fig.3 comprising a layered structure of solar cells 3, an isolation layer 6 and a backsheet 4. The thickness T of the solar cell arrangement 10 is between 0.1 to 3 mm, preferably between 0.2 to 2 mm, more preferably between 0.5 to 1 mm. This thickness T is, as schematically illustrated on Fig.3, measured between the outer surface of the solar cells 3 and the outer side of the backsheet 4, i.e. the outer side of the polymer carrier film 4b.

In further embodiments the connecting circuit 4 may be integrated on the rear panel 2b. For example, the connecting circuit may be obtained by depositing a conductive material on a surface of the rear panel 2b, e.g. a glass panel. In this way an interconnection pattern integrated on top of the rear panel may be formed. Details of such interconnection pattern integrated on a glass panel will be disclosed in patent application EP62041055.

As further schematically illustrated on Fig. 1, the solar cell arrangement, comprising at least the plurality of cells 3 and the patterned connecting circuit 4, is packed between the front 2a and rear panel 2b of the photovoltaic module 1.

The photovoltaic module 1 further comprises an edge sealant 5 that is located between a circumferential edge of the rear panel and a circumferential edge of the front panel. The edge sealant 5 is a seal that is configured for forming an air-tight area 8 between the front 2a and rear panel 2b. In this way, the solar cell arrangement located between the front and rear panel is air-tightly closed off.

In embodiments, the edge sealant 5 comprises one or more layered flexible tapes. In embodiments, the edge sealant 5 comprises at least two layers of flexible tape wherein a first flexible tape is contacting the rear panel and a second flexible tape, placed on top of the first flexible tape, that is contacting the front panel.

The edge sealant may for example have a width WS, schematically illustrated on Fig.1, between 7 and 15 mm and a thickness TS between 0.1 mm and 6.0 mm, preferably a thickness TS between 0.1 mm and 4.0 mm, more preferably a thickness TS between 0.1 mm and 3.0 mm.

The thickness TS of the edge sealant is generally at least equal to a thickness T of the solar cell arrangement but it may also be smaller or even larger. Indeed, the thickness TS of the edge sealant may depend on a separation distance SD between the edge of the solar cells 3 and the edge of the panels 2a, 2b and on the thickness of the panels TP. If this separation distance SD is zero then the thickness of the edge sealant should generally be equal to the thickness of the solar cell arrangement. On the other hand, if this separation distance is non-zero, then the thickness of the edge sealant could be larger or smaller than the thickness of the solar cell arrangement, depending if the edges of the solar panels are bending aways from each other or bending towards each other.

The inventors have found that there is preferably a maximum value for the thickness TS of the edge sealant, which may be expressed as follows: TS ≤ ((SD/(TP x TP x 37.5)) + T), with T being the thickness of the solar cell arrangement, TP being the thickness of the panels and SD being the separation distance between the edge of the solar cels and the edge of the panels.

In embodiments, the edge sealant is a polymer sealant, for example a butyl sealant. In embodiments, the edge sealant may be formed as a polymer film, e.g. a EVA, POE, or TPO film.

In some embodiments, the edge sealant may be provided with a rigid inside frame which may act as a spacer. In further embodiments a separate metal spacer placed at the edges of the front and rear panel may be combined with a adhesive or double-sided tape.

In embodiments, the edge sealant may comprise a one or two component liquid adhesive.

The pressure inside the air-tight area 8 is a vacuum pressure, i.e. the pressure is below atmospheric pressure. The pressure inside the air-tight area 8, i.e. the absolute pressure, is generally equal or below 200 mbar, preferably equal or below 100 mbar, more preferably equal or below 10 mbar. In embodiments, the vacuum pressure may even be lower and for example be equal or lower than 2 mbar.

As will be discussed below, as a result of the PV manufacturing process, the remaining fluid in the area 8 that is creating the vacuum pressure is remaining air resulting from an air evacuation procedure wherein a pressure is reduced from air atmospheric pressure down to the air vacuum pressure.

In this way, by providing a PV module wherein a vacuum is created between the front and rear panel, the front and rear panel are kept pressed together due to the atmospheric pressure and hence the solar cell arrangement is firmly maintained squeezed between the front and rear panel. In this way, a mechanically stable fixation is obtained and the dissipation of power through for instance the glass front and/or glass rear panel is improved. Advantageously, no encapsulant needs to be used and hence recycling of the photovoltaic module is facilitated.

In embodiments, as further schematically shown on Fig.1 and Fig.3, the solar cell arrangement 10 comprises an isolation layer 6 separating the conductive backsheet 4 from the backside of the plurality of solar cells 3. The solar cell arrangement 10 further comprises a plurality of interconnections 7 configured for electrically and mechanically connecting the one or more contacts of each of the solar cells 3 with the conductive backsheet 4. The one or more interconnections 7 are disposed through corresponding interconnection holes made in the isolation layer 6. The interconnections may for example be formed from an electrical conductive adhesive paste or from a low temperature solder paste.

In the embodiment shown on Fig.3, the isolation layer 6 is shown to have a surface corresponding to an area of the solar cell 6. In other embodiments, the isolation layer may be stretched outside the cell area.
Typically, the PV module comprises at least one output terminal 9, for example for outputting an electrical current. The at least one output terminal 9 comprises one or more electrical wires that are electrically connected with the connecting circuit 4 located inside the air-tight area 8.
In embodiments, the at least one output terminal is provided on one of the sides of the PV module. Generally, an additional layer of sealant may be used around or partly around the terminal to provide for a more robust sealing. In further embodiments, the output terminal may be provided on the front and/or rear glass panel sides. In these embodiments, the front and/or rear panels of the PV module may be provided with one or more holes forming a feedthrough for cabling or electrical conductors, and the one or more holes may be sealed off with an additional seal.

### Method of manufacturing a photovoltaic module

According to a further aspect of the invention, a method of manufacturing a PV module as discussed above is provided.

In a first manufacturing embodiment, during a first phase, a semi-fabricate laminated structure is formed wherein the semi-fabricate comprises the solar cell arrangement. The semi fabricate may for example be a back-contact based semi-fabricate, as further discussed here below. During a second phase, distinct from the first phase, the semi-fabricate is integrated in between a front and rear panel of a PV module, e.g. in between front and rear glass panels, so as to form a laminated PV module. By first forming a semi-fabricate during a first phase, the semi-fabricate, i.e. the solar cell arrangement, may for example be functional tested before starting the second phase of integration between front and rear panels.

In a second manufacturing embodiment, the laminated photovoltaic module is formed during a single phase and hence no semi-fabricate is formed and the testing is only performed after completion of the entire laminated photovoltaic module.

What the first and second manufacturing embodiment have in common is that the integration of the solar cell arrangement or the integration of the components of the solar cell arrangement between the front and rear panel of the PV module comprises two major processing steps performed in a sequential order. The first processing step is a pre-assembly step wherein a layered structure is formed, i.e. wherein the various components such as for instance the front panel 2a, the rear panel 2b, the solar cells 3, the isolation layer 6, and the conductive backsheet 4 are layer wise positioned on top of each other, and wherein an edge sealant 5 is provided between edges of the front and rear panel. The second step, following the first step of pre-assembling, is a lamination step, preferably performed with a PV laminator apparatus, and wherein during the lamination step, the area 8 under vacuum that is air-tightly closing off the solar panel assembly 10, is created.

The method of manufacturing a photovoltaic module according to the present invention that is applicable for both the first and second manufacturing embodiment as discussed above, comprises: a) pre-assembling a photovoltaic module and b) applying a lamination process to the pre-assembled photovoltaic module.

The step of pre-assembling a photovoltaic module comprises at least: - providing a front 2a and rear 2b panel for forming respectively a front and a rear side of the photovoltaic module, - forming a solar cell arrangement by electrically interconnecting a plurality of solar cells 3, - placing the solar cell arrangement between the rear panel and the front panel, and - placing an edge sealant 5 between a circumferential edge of the rear panel and a circumferential edge of the front panel.

As mentioned above, the front and rear panel used for manufacturing the PV module are rigid panels. For instance made of glass.

Preferably, the placing of the edge sealant 5 is performed such that a first side of the edge sealant is contacting a circumferential edge of the rear panel and a second side of the edge sealant, opposite the first side, is contacting a circumferential edge of the front panel.

The step of applying a lamination process to the pre-assembled photovoltaic module is performed using a laminator apparatus, e.g. a PV laminator apparatus, comprising one or more heating elements and a press mechanism. A PV laminator apparatus is for instance known in the art for manufacturing conventional PV modules.
The lamination process according to the present invention comprises at least:
- inserting the pre-assembled photovoltaic module in a chamber of the laminator apparatus,
- pumping air from the chamber such that the entire pre-assembled photovoltaic module becomes placed under vacuum including an area between the front 2a and rear 2b panel, and wherein the vacuum has a vacuum pressure equal or lower than 200 mbar, preferably equal or lower than 100 mbar, more preferably equal or lower than 10 mbar.
- heating the pre-assembled photovoltaic module by using the one or more heating elements,
- using the press mechanism for exercising a pressure force on an outside surface of the front panel and/or an outside surface of the rear panel such that the front and rear panel are squeezed together while applying the heating,
- controlling the heating and the pressure force such that the edge sealant is air-tightly sealing off the area between the front and rear panel and the solar cell arrangement packed between the front and rear panel becomes enclosed under vacuum,
- ventilating the chamber of the lamination apparatus until the chamber reaches atmospheric pressure and removing the photovoltaic module from the lamination apparatus. Due to the vacuum in the air-tightly sealed off area between front and rear panels, the atmospheric pressure provides for a permanent mechanical pressure maintaining the solar cell arrangement squeezed between the front and rear panel.

The exact vacuum that can be reached in the chamber of the laminator apparatus may vary from embodiment to embodiment and depends on the details of the laminator apparatus and pumping capacity available, preferably, the vacuum is as low as possible. In embodiments, the vacuum pressure may be equal or lower than 2 mbar.

Advantageously, due to the mechanical pressure that is permanently squeezing the front and rear panels together, no encapsulant or glue is required to hold the components of the solar cell arrangement together.

Generally, during the lamination process, the heating of the photovoltaic module is performed until a temperature is reached in a range between 80°C and 200°C, preferably in range between 100°C and 160°C. More preferably, the heating is performed until a temperature is reached where the edge sealant starts softening or melting. An optimum temperature may depend on the type of sealant that is used. In embodiments the melting temperature of the edge sealant may be in a range between 80°C and 150°C. Indeed, by heating the photovoltaic module, also the edge sealant will heat up and when the temperature is sufficiently high, the edge sealant will start softening and/or melting. In combination with the applied pressure force that is squeezing the front and rear panel together, the edge sealant will close off any remaining gaps or voids between the edge sealant and the front and rear panel.

The pressure force exercised by the press mechanism generally corresponds to a pressure between 5 mbar and 500 mbar, preferably between 10 mbar and 200 mbar, more preferably between 15 mbar and 100 mbar.

Remark that that by pumping air from the chamber of the lamination apparatus to form a vacuum, air is also evacuated from the area between the front and rear panel of the PV module as air is pumped through air gaps between the edge sealant and the front panel and/or between the edge sealant and the rear panel. As mentioned above, after the vacuum is established, these air gaps are closed off by controlling the heating of the PV module and by controlling the force exercised on the front and/or rear panel.

In embodiments, before exercising the pressure force on the front and/or rear panel to squeeze the panels together, the heating of the PV module is started while and air is pumped from the chamber for forming a vacuum. For reaching a target temperature a first time period is required, and generally the first time period is between 200 seconds 1200 seconds, preferably between 500 seconds and 1000 seconds. Thereafter, while continuing pumping of the air to maintain the vacuum in the chamber, the pressure force on the front and/or rear panel is gradually applied until a maximum force is reached and then the maximum pressure force may be maintained during a further second time period, i.e. a holding time, which is for example between 50 seconds to 300 seconds.

Hence, in general the total time for performing the lamination process of a PV module, corresponding to the time the PV module has to stay inside a PV laminator apparatus for performing the lamination process, is generally between 700 seconds to 2000 seconds, preferably between 800 seconds to 1500 seconds.

Optionally, after removing the PV module from the laminator apparatus, a cool down period may be provided to have the PV module cool down to room temperature.

In embodiments, the step of applying a lamination process is performed with a laminator apparatus comprising a first chamber and a second chamber separated from the first chamber by a membrane. The two chambers and the separating membrane provide for the press mechanism.

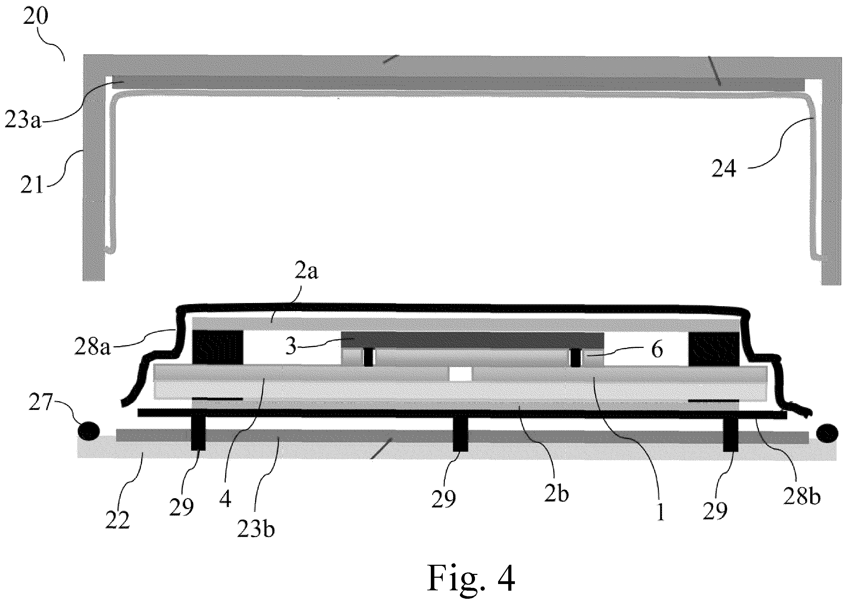

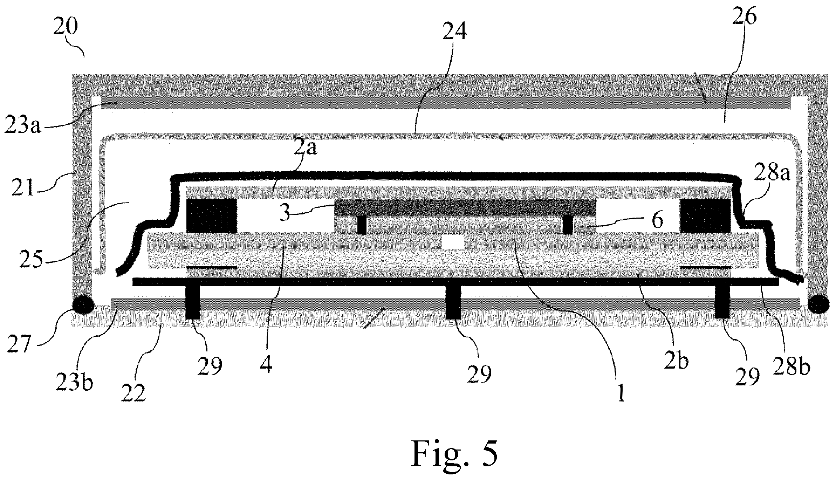

An exemplary embodiment of a part of an embodiment of a PV laminator apparatus 20 that may be used to perform the lamination process of the pre-assembled PV module is schematically shown on Fig.4 and Fig.5, wherein the laminator apparatus 20 is respectively in an open position and a closed position. To open the PV laminator apparatus 20, a cover 21 of the laminator is separated from a bottom side 22 of the laminator. As shown on Fig.4, the laminator apparatus 20, when in open position, may receive the pre-assembled PV module 1 for starting the lamination process, as discussed above. As shown on Fig.5, when the PV laminator apparatus 20 is closed, it is sealed off by a laminator seal 27, e.g. an O-ring, such that a vacuum may be created in the PV laminator apparatus. The membrane 24 is separating a first chamber 25 from a second chamber 26. The PV laminator further comprise a top heating plate 23a and a bottom heating plate 23b. The top and bottom heating plate allow to heat up the PV module. When the pre-assembled PV module 1 is placed in the first chamber, it may be lifted up and down using mechanical pins 29 to adjust a distance between the pre-assembled PV module and the bottom heating plate 23b. By initially lifting up the PV module with the pins 29, the heating of the PV module may be performed more uniformly.

Optionally, a release layer 28a, e.g. a flexible PTFE or ETFE sheet may be used to cover the pre-assembled PV module when placed in the PV laminator apparatus. Additionally, a further protection sheet 28b, e.g. a PTFE sheet may be located under the rear glass panel.

In these embodiments wherein lamination is performed with such a PV laminator apparatus comprising two chambers and a separating membrane, for applying the lamination process, the pre-assembled photovoltaic module is inserted in the first chamber.

During a first time period air is pumped from the first and the second chamber such that a vacuum is formed in both the first and second chamber. Thereafter, during a second time period following the first time period the pressure in the second chamber is increased and the vacuum pressure in the first chamber is maintained constant so as to form a pressure difference between the second and the first chamber. The membrane separating the second chamber from the first chamber is configured such that if the pressure in the second chamber is higher than the pressure in the first chamber, exercising a pressure force on an outside surface of the front panel and/or an outside surface of the rear panel is performed by the membrane pushing against the outside surface of the front panel and/or or the outside surface of the rear panel.

In embodiments, the pressure difference between the first and second chamber, resulting from the increase of pressure in the second chamber, is equal or larger than 10 mbar, preferably equal or larger than 20 mbar, more preferably equal or larger than 30 mbar.

As mentioned above, in embodiments, the solar cell arrangement may optionally be formed as a semi fabricate in order to allow the solar cell arrangement to be tested prior to fully assemble and complete the PV end product.

In embodiments, forming a solar cell arrangement 10 comprises preparing a back-contact based semi fabricate, and wherein preparing the semi fabricate comprises at least:
- providing a plurality of solar cells 3, wherein each of the plurality of solar cells is a back contact solar cell wherein a backside of the solar cell comprises one or more electrical contacts for interconnecting the solar cells,
- providing a conductive backsheet 4 forming a patterned connecting circuit for connecting the plurality of back contact solar cells,
- providing an interconnecting paste 7 on each of the one or more electrical contacts of the solar cells for making an electrical contact with the conductive backsheet, or providing an interconnecting paste 7 on contact locations on the conductive backsheet that need to make an electrical contact with the one or more electrical contacts of the solar cells,
- providing an isolation layer 6 for forming a separation layer between the conductive backsheet and the solar cells, and wherein the isolation layer is provided with holes for receiving the interconnecting pastes,
- forming a stacked solar cell arrangement 10 by placing the isolation layer 6 on top of the conductive backsheet 4 and placing the plurality of solar cells 3 on top of the isolation layer,
- positioning the stacked solar cell arrangement on a carrier plate such that the conductive backsheet is resting on the carrier plate, preferably wherein the carrier plate is for example a metal or glass plate,
- applying a lamination process to the stacked solar cell arrangement using a laminator apparatus, wherein the lamination process comprises:
   - inserting the stacked solar cell arrangement together with the carrier plate in the chamber of the laminator apparatus,
   - pumping air from the chamber such that the stacked solar cell arrangement becomes placed under vacuum, preferably wherein the vacuum has a vacuum pressure equal or below 200 mbar, preferably equal or below 100 mbar, more preferably equal or below 10 mbar,
   - heating the stacked solar cell arrangement by using the one or more heating elements,
   - while applying the heating using the press mechanism for exercising a pressure force and squeezing the stacked solar cell arrangement together, preferably wherein the pressure force corresponds to a pressure between 100 mbar and 1100 mbar, preferably between 400 mbar and 1100 mbar, more preferably between 500 mbar and 1000 mbar, and
   - controlling the heating such that the interconnecting pastes 7 are cured or melted and form electrical connections between the solar cells and the conductive backsheet,
   - ventilating the chamber of the lamination apparatus until the chamber reaches atmospheric pressure and removing the solar cell arrangement from the lamination apparatus, preferably allowing the solar cell arrangement to cool down.

The lamination process of the semi fabricate may further comprise an optional step of removing the carrier plate.

In embodiments, during the processing of the semi fabricate the heating of the stacked solar cell arrangement is performed until a temperature is reached in a range between 80°C and 180°C, preferably in range between 100°C and 160°C, more preferably in a range between 120°C and 150°C. For example, in embodiments, a temperature of 145°C may be reached for curing or melting the interconnecting pastes.

The interconnecting paste is for example an electrical conductive adhesive paste or a low temperature solder paste, known in the art. After treatment in the oven, the interconnecting pastes form solid interconnections 7 between the solar cells 3 and the conductive backsheet 4.

The same or a similar laminator apparatus as discussed above for laminating the PV module may be used for laminating the semi fabricate. The stacked solar cell arrangement is hereby placed in the first chamber. The pressing mechanism of the laminator apparatus is formed by providing a differential pressure between the first chamber and second chamber such that the membrane is exercising a pressure force on the solar cells and the solar cells are pressed against the conductive backsheet resting on the carrier plate. In embodiments, for generating the pressure difference between the first and second chamber, the pressure inside the first chamber is kept for example at a pressure between 1 mbar and 2 mbar and the pressure of the second chamber is kept for example at a pressure between 100 mbar and 1100 mbar, preferably between 400 mbar and 1100 mbar, more preferably between 500 mbar and 1000 mbar.

The pressure force exercised during the lamination process of the semi fabricate solar cell arrangement, helps to keep the conductive backsheet, the isolation layer and the solar cells in place and to keep all flat.

In embodiments, during the lamination process of the semi fabricate solar cell arrangement the pressure force is applied during a time period between 100 seconds and 1000 seconds, preferably between 300 seconds and 900 seconds, more preferably between 400 seconds and 700 seconds.

In embodiments, a flexible sheet, such as a PTFE or a ETFE sheet may be placed between the carrier plate and the conductive backsheet in order to facilitate, after the lamination process, the removal of the semi-fabricate from the carrier plate. During the lamination process, the top of the stacked solar cell arrangement may also be covered with such a flexible sheet.

In other embodiments, no semi fabricate solar cell arrangement is manufactured and a direct assembly route is followed wherein the solar cell arrangement 10 is assembled as part of the overall PV module pre-assembly.

In these embodiments wherein a direct assembly route is followed, the solar cell arrangement 10 is formed as part of the pre-assembly process of the PV module discussed above. The formation of the solar cell arrangement following the direct assembly route comprises sub-steps of:
- providing a plurality of solar cells 3, wherein each of the plurality of solar cells is a back contact solar cell wherein a backside of the solar cell comprises one or more electrical contacts for interconnecting the back contact solar cells,
- providing a conductive backsheet 4 forming a patterned connecting circuit for connecting the plurality of back contact solar cells,
- providing an interconnecting paste 7 on each of the one or more electrical contacts of the solar cells, or providing an interconnecting paste on contact locations on the conductive backsheet that need to make an electrical contact with the one or more electrical contacts of the solar cells,
- providing an isolation layer 6 for forming a separation layer between the conductive backsheet and the solar cells, and wherein the isolation layer is provided with holes for receiving the interconnecting pastes,
- placing the conductive backsheet 4 on top of the rear panel 2b,
- placing the isolation layer 6 on top of the conductive backsheet 4, and
- placing the plurality of solar cells 3 on top of the isolation layer 6.

Hence, if following the direct assembly route, the curing or melting of the interconnecting pastes to form electrical and mechanical interconnections 7 between the solar cells 3 and the conductive backsheet 4 is established as part of the overall lamination process of the pre-assembled PV module, discussed above.

In embodiments, the edge sealant comprises one or more layered flexible tapes. For example, the edge sealant may comprise at least two layers of flexible tape wherein a first flexible tape is contacting the rear panel and a second flexible tape, placed on top of the first flexible tape, is contacting the front panel. Depending on the number of flexible layers that are used for forming the edge sealant, the skilled person will adapt the method step of placing the edge sealant between edges of the front and rear panel.

For example, for embodiments wherein the edge sealant comprises two flexible tapes, the step of placing an edge sealant may comprise sub-steps of: placing a first flexible tape around the edge of the rear panel, and after placing the solar cell arrangement on top of the rear panel, placing a second flexible tape on top of the first flexible tape. Finally, the front panel is positioned on top of the solar cell assembly such that the edge of the front panel is contacting the second flexible tape.

The second flexible tape is generally also covering the output terminal. In embodiments, additional tape may placed around the output terminal.

In embodiments, the flexible tape used for forming the edge sealant may have a width between 7 mm and 15 mm, for example a width of 12.7 mm.

In embodiments, wherein the edge sealant is formed from one or more layers of flexible tape, a total thickness of the one or more layers of flexible tape is at least equal to a thickness of the stacked solar cell arrangement.

In embodiments, to finalize the manufacturing process of the PV module, a metal frame may be attached to the edges of PV module.

### Reference numbers

| | |
|---|---|
| 1 | Photovoltaic module |
| 2a | Front panel |
| 2b | Rear panel |
| 3 | Solar cell |
| 4 | Connecting circuit/conductive backsheet |
| 4a | patterned copper top layer |
| 4b | polymer carrier film |
| 5 | Edge sealant |
| 6 | Isolation layer |
| 7 | interconnection |
| 8 | Air-tight area under vacuum |
| 10 | Solar cell arrangement |
| 20 | PV Laminator apparatus |
| 21 | Cover of the laminator |
| 22 | Bottom side of the laminator |
| 23a | Top heating plate |
| 23b | Bottom heating plate |
| 24 | membrane |
| 25 | First chamber |
| 26 | Second chamber |
| 27 | Laminator seal |
| 28a, 28b | Release layer |
| 29 | mechanical pin |

## Claims

1. A photovoltaic module comprising:
- a front panel,
- a rear panel opposite the front panel,
- a solar cell arrangement comprising a plurality of electrically interconnected solar cells, and wherein the solar cell arrangement is packed between the front and rear panel, and
- an edge sealant located between an edge of the rear panel and an edge of the front panel, and wherein the edge sealant is configured for forming an air-tight area between the front and rear panel such that the solar cell arrangement packed between the front and rear panel is air-tightly closed off,
and wherein said air-tight area is under vacuum with a vacuum pressure equal or below 200 mbar, preferably equal or below 100 mbar, more preferably equal or below 10 mbar, such that the solar cell arrangement is maintained squeezed between the front and rear panel.

2. The photovoltaic module according to claim 1 wherein each of the plurality of solar cells is a back contact solar cell wherein a backside of the solar cell comprises one or more electrical contacts for interconnecting the solar cells, and wherein said backside is facing towards the rear panel and a frontside of the solar cell, opposite the backside, is facing the front panel, preferably wherein for each of the plurality of solar cells the frontside of the solar cell is contacting the front panel.

3. The photovoltaic module according to claim 2 wherein the solar cell arrangement comprises:
- a conductive backsheet forming a patterned connecting circuit electrically interconnecting the plurality of solar cells,
- an isolation layer separating the conductive backsheet from the backside of the plurality of solar cells, and
- a plurality of interconnections configured for electrically and mechanically connecting the one or more contacts of each of the solar cells with the conductive backsheet, and wherein said one or more interconnections are disposed through corresponding interconnection holes provided in the isolation layer.

4. The photovoltaic module according to claim 3 wherein the conductive backsheet comprises a polymer carrier film and a patterned copper top layer.

5. The photovoltaic module according to any of previous claims comprising at least one output terminal, wherein the at least one output terminal comprises one or more electrical wires that are electrically connected with the connecting circuit located inside the air-tight area.

6. The photovoltaic module according to any of previous claims wherein the photovoltaic module is an encapsulant free module, preferably wherein no encapsulant foil, such as for example an EVA or POE foil, is covering or partly covering the solar cell arrangement, or, wherein the photovoltaic module is module wherein no layer of glue is provided between the front panel and the solar cell arrangement and no layer of glue is provided between the rear panel and the solar cell arrangement.

7. A method of manufacturing a photovoltaic module comprising:
a) pre-assembling a photovoltaic module, wherein pre-assembling comprises at least:
- providing a front and rear panel for forming respectively a front and a rear side of the photovoltaic module,
- forming a solar cell arrangement by electrically interconnecting a plurality of solar cells,
- placing the solar cell arrangement between the rear panel and the front panel, and
- placing an edge sealant between a circumferential edge of the rear panel and a circumferential edge of the front panel,
b) applying a lamination process to the pre-assembled photovoltaic module using a laminator apparatus comprising one or more heating elements and a press mechanism, the lamination process comprising at least:
- inserting the pre-assembled photovoltaic module in a chamber of the laminator apparatus,
- pumping air from said chamber such that the entire pre-assembled photovoltaic module becomes placed under vacuum including an area between the front and rear panel, and wherein said vacuum has a vacuum pressure equal or lower than 200 mbar, preferably equal or lower than 100 mbar, more preferably equal or lower than 10 mbar
- heating the pre-assembled photovoltaic module by using the one or more heating elements,
- using the press mechanism for exercising a pressure force on an outside surface of the front panel and/or an outside surface of the rear panel such that the front and rear panel are squeezed together while applying said heating,
- controlling said heating and said pressure force such that the edge sealant is air-tightly sealing off the area between the front and rear panel and the solar cell arrangement packed between the front and rear panel becomes enclosed under vacuum,
- ventilating said chamber of the lamination apparatus until the chamber reaches atmospheric pressure and removing the photovoltaic module from the lamination apparatus, and wherein due to the vacuum in the air-tightly sealed off area between front and rear panels the atmospheric pressure provides for a permanent mechanical pressure maintaining the solar cell arrangement squeezed between the front and rear panel.

8. The method according to claim 7 wherein said heating of the photovoltaic module is performed until a temperature is reached in a range between 80°C and 200°C, preferably in range between 100°C and 160°C, more preferably until a temperature is reached where the edge sealant starts softening or melting.

9. The method according to claim 7 or claim 8, wherein said pressure force exercised by the press mechanism corresponds to a pressure between 5 mbar and 500 mbar, preferably between 10 mbar and 200 mbar, more preferably between 15 mbar and 100 mbar, preferably wherein said pressure force is maintained during a time period between 50 seconds and 300 seconds.

10. The method according to any of claims 7 to 9 wherein said pumping
air from the chamber comprises evacuating air from said area between front and rear panel by pumping air through air gaps between the edge sealant and the front panel and/or between the edge sealant and the rear panel, and wherein said air gaps are closed off by controlling said heating of the photovoltaic module and by controlling said pressure force.

11. The method according to any of claims 7 to 10 wherein said laminator apparatus comprises a first chamber and a second chamber separated from the first chamber by a membrane, and wherein for applying the lamination process the pre-assembled photovoltaic module is inserted in the first chamber,
and wherein during a first time period air is pumped from the first and the second chamber such that a vacuum is formed in both the first and second chamber, and wherein during a second time period following the first time period the pressure in the second chamber is increased and the vacuum pressure in the first chamber is maintained constant so as to form a pressure difference between the second and the first chamber, and wherein the membrane is configured such that if the pressure in the second chamber is higher than the pressure in the first chamber said exercising a pressure force on an outside surface of the front panel and/or an outside surface of the rear panel is performed by the membrane pushing against the outside surface of the front panel and/or or the outside surface of the rear panel.

12. The method according to any of claims 7 to 11 wherein said forming a solar cell arrangement comprises preparing a back-contact based semi fabricate, and wherein preparing the semi fabricate comprises at least:
- providing a plurality of solar cells, wherein each of the plurality of solar cells is a back contact solar cell wherein a backside of the solar cell comprises one or more electrical contacts for interconnecting the solar cells,
- providing a conductive backsheet forming a patterned connecting circuit for connecting the plurality of back contact solar cells,
- providing an interconnecting paste on each of said one or more electrical contacts of the solar cells for making an electrical contact with the conductive backsheet, or providing an interconnecting paste on contact locations on the conductive backsheet that need to make an electrical contact with the one or more electrical contacts of the solar cells,
- providing an isolation layer for forming a separation layer between the conductive backsheet and the solar cells, and wherein the isolation layer is provided with holes for receiving the interconnecting pastes,
- forming a stacked solar cell arrangement by placing the isolation layer on top of the conductive backsheet and placing the plurality of solar cells on top of the isolation layer,
- positioning the stacked solar cell arrangement on a carrier plate such that the conductive backsheet is resting on the carrier plate, preferably wherein the carrier plate is for example a metal or glass plate,
- applying a lamination process to the stacked solar cell arrangement using said laminator apparatus or using a further laminator apparatus, wherein the lamination process comprises:
• inserting the stacked solar cell arrangement together with the carrier plate in the chamber of the laminator apparatus,
• pumping air from the chamber such that the stacked solar cell arrangement becomes placed under vacuum, preferably wherein said vacuum has a vacuum pressure equal or below 200 mbar, preferably equal or below 100 mbar, more preferably equal or below 10 mbar,
• heating the stacked solar cell arrangement by using the one or more heating elements,
• while applying said heating using the press mechanism for exercising a pressure force and squeezing the stacked solar cell arrangement together, preferably wherein said pressure force corresponds to a pressure between 100 mbar and 1100 mbar, preferably between 400 mbar and 1100 mbar, more preferably between 500 mbar and 1000 mbar, and
• controlling said heating such that the interconnecting pastes 7 are cured or melted and form electrical connections between the solar cells and the conductive backsheet, preferably wherein said heating of the stacked solar cell arrangement is performed until a temperature is reached in a range between 80°C and 180°C, preferably in range between 100°C and 160°C, more preferably in a range between 120°C and 150°C,
• ventilating the chamber of the lamination apparatus until the chamber reaches atmospheric pressure and removing the solar cell arrangement from the lamination apparatus, preferably allowing the solar cell arrangement to cool down.

13. The method according to any of claims 7 to 11 wherein said forming a solar cell arrangement comprises:
- providing a plurality of solar cells, wherein each of the plurality of solar cells is a back contact solar cell wherein a backside of the solar cell comprises one or more electrical contacts for interconnecting the back contact solar cells,
- providing a conductive backsheet forming a patterned connecting circuit for connecting the plurality of back contact solar cells,
- providing an interconnecting paste on each of said one or more electrical contacts of the solar cells for making an electrical contact with the conductive backsheet, or providing an interconnecting paste on contact locations on the conductive backsheet that need to make an electrical contact with the one or more electrical contacts of the solar cells,
- providing an isolation layer for forming a separation layer between the conductive backsheet and the solar cells, and wherein the isolation layer is provided with holes for receiving the interconnecting pastes,
- placing the conductive backsheet on top of the rear panel,
- placing the isolation layer on top of the conductive backsheet, and
- placing the plurality of solar cells on top of the isolation layer.

14. The photovoltaic module according to any of claims 1 to 6 or the method according to any of claims 7 to 13 wherein the edge sealant comprises one or more layered flexible tapes, preferably wherein the edge sealant comprises at least two layers of flexible tape wherein a first flexible tape is contacting the rear panel and a second flexible tape, placed on top of the first flexible tape, is contacting the front panel.

15. The photovoltaic module according to any of claims 1 to 6 and claim 14 or the method according to any of claims 8 to 13 and claim 14, wherein the front panel is made of a transparent material, preferably wherein the front panel is made of glass, and/or wherein the rear panel is made of a transparent material, preferably wherein the rear panel is made of glass.
